# EUROPÄISCHE PATENTSCHRIFT

(11) **EP 0 958 195 B1**
(45) Veröffentlichungstag und Bekanntmachung des Hinweises auf die Patenterteilung: **02.01.2002**
(21) Anmeldenummer: 98955326.8
(22) Anmeldetag: 15.09.1998
(51) Int. Cl.: B65D 81/05

(54) **VERFAHREN ZUR SPUTTERBESCHICHTUNG VON OBERFLÄCHEN**
METHOD FOR COATING SURFACES USING AN INSTALLATION WITH SPUTTER ELECTRODES
PROCEDE DE REVETEMENT DE SURFACES AU MOYEN D'UNE INSTALLATION DOTEE D'ELECTRODES DE DEPOT PAR PULVERISATION

(30) Priorität: 17.09.1997 DE 19740793
(43) Veröffentlichungstag der Anmeldung: 24.11.1999
(73) Patentinhaber: ROBERT BOSCH GMBH, 70442 Stuttgart (DE)
(72) Erfinder: WEBER, Thomas, D-70825 Korntal-Münchingen (DE); VOIGT, Johannes, D-71229 Leonberg (DE); LUCAS, Susanne, D-70195 Stuttgart (DE)
(74) Vertreter: Gleiss & Grosse
(86) Internationale Anmeldenummer: DE9802726
(87) Internationale Veröffentlichungsnummer: WO9914390

(56) Entgegenhaltungen:
- EP-A- 0 583 736
- EP-A- 0 736 612
- DE-A- 19 537 263
- DE-C- 4 343 042
- DE-C- 19 506 515
- FRACH P ET AL: "The double ring magnetron process module-a tool for stationary deposition of metals, insulators and reactive sputtered compounds" SURFACE AND COATINGS TECHNOLOGY, 15 MARCH 1997, ELSEVIER, SWITZERLAND, Bd. 90, Nr. 1-2, Seiten 75-81, XP002094930 ISSN 0257-8972
- SCHOLL R A: "ASYMMETRIC BIPOLAR PULSED POWER. A NEW POWER TECHNOLOGY" LE VIDE: SCIENCE, TECHNIQUE ET APPLICATIONS, Bd. 52, Nr. 280, 1. April 1996, Seiten 237-243, XP000599220
- KUSAKA K ET AL: "EFFECT OF NITROGEN GAS PRESSURE ON RESIDUAL STRESS IN AIN FILMS DEPOSITED BY THE PLANAR MAGNETRON SPUTTERING SYSTEM" THIN SOLID FILMS, Bd. 281/282, Nr. 1/02, 1. August 1996, Seiten 340-343, XP000643420
- YOSHIO MANABE ET AL: "ZINC OXIDE THIN FILMS PREPARED BY THE ELECTRON-CYCLOTRON-RESONANCE PLASMA SPUTTERING METHOD" JAPANESE JOURNAL OF APPLIED PHYSICS, Bd. 29, Nr. 2, PART 01, 1. Februar 1990, Seiten 334-339, XP000116850
- SHEW B -Y ET AL: "Effects of r.f. bias and nitrogen flow rates on the reactive sputtering of TiAlN films" THIN SOLID FILMS, Bd. 293, Nr. 1-2, 30. Januar 1997, Seite 212-219 XP004080859
- PATENT ABSTRACTS OF JAPAN vol. 005, no. 120 (C-065), 4. August 1981 & JP 56 055564 A (MITSUBISHI METAL CORP), 16. Mai 1981
- SMITH P.H.: "Method of Varying Composition of Multi Component. Sputtered Films. November 1981." IBM TECHNICAL DISCLOSURE BULLETIN, Bd. 24, Nr. 6, November 1981, Seiten 2962-2963, XP002094096 New York, US

## Beschreibung

### Stand der Technik

Die Erfindung betrifft ein Verfahren zur Beschichtung von Oberflächen mittels einer Anlagedie zumindest zwei beabstandet zueinander und innerhalb einer Prozeßkammer angeordnete Elektroden, und einen Einlaß für ein Prozeßgas aufweist.

In der Druckschrift DD 252 205 A1 ist eine Zerstäubungseinrichtung offenbart, die zur Herstellung dünner Schichten mittels einer Vakuumbeschichtung geeignet ist. Insbesondere lassen sich mit dieser Einrichtung dielektrische Schichten abscheiden. Die Zerstäubungseinrichtung umfaßt zumindest zwei Elektroden und Magnetsysteme, wobei die Elektroden elektrisch so geschaltet werden , daß sie wechselweise eine Anode und eine Kathode bilden. Als besonders vorteilhaft hat sich eine sinusförmige Wechselspannung von 50 Hz herausgestellt. Bei dieser Einrichtung erfolgt der Materialabtrag von den Elektroden, so daß durch die Wechselspannung alle Elektroden gleichmäßig abgetragen werden.

Allgemein sind dem Fachmann sogenannte Magnetron-Sputter-Anlagen bekannt. Sie werden beispielsweise zur Abscheidung von verschleißfesten, metallhaltigen Kohlenstoffschichten verwendet. Dabei wird ein kohlenstoffhaltiges Gas in einen Prozeßraum beziehungsweise eine Prozeßkammer der Anlage eingelassen, im Sputterprozeß auf der mit einer Gleichspannung beaufschlagten Metall-Kathodenoberfläche geeignet umgesetzt und auf den in der Prozeßkammer sich befindenden Substraten zusammen mit Metallatomen und Wasserstoff als Schicht abgeschieden. Das sich in der Prozeßkammer verfahrensbedingt ausbildende Beschichtungsplasma ist im wesentlichen vor den Sputterkathoden lokalisiert. Die Beschichtung ist durch die großflächigen Kathoden sehr gleichmäßig, jedoch auch gerichtet. Zudem läßt sich die Beschichtungsrate und damit die Wirtschaftlichkeit des Verfahrens nicht beliebig steigern. Die Beschichtungsrate läßt sich zwar mit einer erhöhten Zugabe des kohlenstoffhaltigen Gases steigern, dies führt jedoch zu dem unerwünschten Effekt, daß die Oberfläche der Kathoden flächig zunehmend mit einer isolierenden kohlenstoffhaltigen Schicht belegt wird. Bei einer vollständigen Bedeckung der Oberflächen der Kathoden ist dann kein stabiler Gleichspannungs-Sputterbetrieb mehr möglich.

Aus der Druckschrift US 3,860,507 ist ein Beschichtungsverfahren bekannt, bei dem zwei diametral sich gegenüberstehende Kathoden (Targets) mit Hochfrequenz (bevorzugt 13,56 Mhz) betrieben werden, so daß sich zwischen den Targets ein Entladungsplasma ausbildet. Die Targets sind an zwei Ausgänge einer Sekundärspule einer Wechselspannungversorgung angeschlossen, von der ein Mittelabgriff zur Wand der Prozeßkammer führt.

Aus der Druckschrift US 5,169,509 ist des weiteren ein Verfahren bekannt, bei dem eine reaktive Beschichtung mit elektrisch isolierenden Schichten dadurch gewährleistet wird, daß zwei Magnetron-Kathoden mit einer Wechselspannung betrieben werden, während ein reaktives Gas in die Prozeßkammer eingeleitet wird.

### Vorteile der Erfindung

Das Verfahren zur Beschichtung von Oberflächen mit den Merkmalen des Anspruchs 1 hat demgegenüber die Vorteile, daß eine hohe Beschichtungsrate, ein stabiler Betrieb und eine Reduktion von Entladungen auf den Elektrodenoberflächen (Mikroarcs) erzielbar sind. Das Verfahren stellt eine Kombination eines Sputterverfahrens und eines plasmaunterstützen CVD-Verfahrens dar. Dies läßt sich dadurch erreichen, daß beispielsweise zwei handelsübliche Sputterkathoden mit einer bipolar gepulsten Spannung beaufschlagt werden, derart, daß sie alternierend als Kathoden und Anoden betrieben werden, wobei die Frequenz dieser Spannung im Bereich von 1 kHz bis 1 Mhz liegt. Die Elektroden sind beispielsweise einander gegenüberstehend angeordnet, während sich die zu beschichtenden Substrate zwischen den Elektroden befinden. Zusätzlich zum sputternden Edelgas wird ein reaktives Prozeßgas eingelassen, daß sich in bekannter Weise teilweise auf den Elektrodenoberflächen niederschlagen kann (Vergiftung der Elektroden). Durch die erfindungsgemäße Verwendung einer bipolar gepulsten Spannung wird zweierlei gewährleistet:
- Zum einen wird erreicht, daß der Prozeß auch bei teilweiser oder vollständiger Bedeckung der Elektroden mit einer elektrisch isolierenden Schicht stabil ablaufen kann. Es sei der Fall betrachtet, daß eine der Elektroden zu einem gegebenen Zeitpunkt an eine negative Spannung angeschlossen ist, somit als Kathode betrieben wird. In diesem Fall wird durch Ionenbeschuß Elektrodenmaterial prozeßgemäß abgetragen, elektrisch isolierende Bereiche der Oberfläche des Elektrodenmaterials jedoch auch elektrisch aufgeladen, bis der Ionenbeschuß infolge der Aufladung und der damit verbundenen elektrostatischen Abstossung in diesen Bereichen auf Null sinkt. Die Abtragsleistung und damit die Beschichtungsrate ist somit reduziert. Ist der elektrisch leitfähige (unbedeckte) Teil der kathodisch geschalteten Elektrodenoberfläche zu klein oder gleich Null, so wird auch das Plasma verlöschen und der Prozeß beendet: ein stabiler Sputterbetrieb ist nicht möglich. Jedoch wird erfindungsgemäß durch Umpolung der anliegenden Elektrodenspannungen erreicht, daß besagte Elektrode in einer anschließenden Zeitperiode als Anode wirkt und somit ein Elektronstrom auf die Oberfläche gezogen wird, der die elektrisch isolierenden und durch vorherigen Ionebeschuß positiv geladen Oberflächenbereiche zunächst elektrisch entlädt und dann negativ auflädt. Durch geeignete Wahl der Frequenz der angelegten bipolaren Elektrodenspannung kann auf diese Weise erreicht werden, daß ein stabiler Betrieb der Elektroden erfolgt und das Plasma nicht erlöscht.
   Gegenüber herkömmlichen Verfahren ist es infolgedessen möglich, mit Elektroden mit stärkerer oder vollständiger Bedeckung zu arbeiten. Dies bedeutet, daß höhere Gasflüsse möglich sind, die Umsetzung des Gases auf den Elektrodenoberflächen in stärkerem Maße erfolgen kann und dadurch die Beschichtungsrate erhöht werden kann.
- Zum anderen verhindert die Verwendung einer gepulsten Elektrodenspannung weitestgehend die Ausbildung von sogenannten Mikroarcs: die Aufladung von elektrisch isolierenden Bereichen der kathodisch geschalteten Elektrodenoberflächen kann schließlich dazu führen, daß es einen Spannungsüberschlag zu einem benachbarten leitfähigen Bereich gibt. Diese "Mikroarc" genannte Entladung auf der Elektrodenoberflächen beeinträchtigt in bekannter Weise den stabilen Betrieb und kann zu einer Veränderung der Elektrodenoberfläche und zu einem Einbau von Störpartikeln in die abzuscheidende Schicht auf den Substraten führen. Durch Verwendung einer bipolar gepulsten Spannung ist die Wahrscheinlichkeit der Mikroarc-Bildung deutlich reduziert.

Als weiterer, entscheidender Vorteil erfolgt erfindungsgemäß eine plasmaunterstützte CVD-Schichtabscheidung aus dem zwischen den Elektroden bewegten Plasma, zusätzlich zur Schichtabscheidung durch Umsetzen des Reaktivgases an den Elektrodenoberflächen. Dies ermöglicht eine deutliche Erhöhung der Beschichtungsrate und die Darstellung von neuen Schichtqualitäten.

Um dies zu erreichen, werden die Parameter der Anlage so gewählt, daß die Plasmen vor den jeweiligen Elektroden nicht kontinuierlich mit der gepulsten Elektrodenspannung entstehen und verlöschen, sondern daß das Plasma von der gerade ausgeschalteten Elektrode zur inbetriebgehenden Elektrode gezogen wird. So wandert ein nicht verlöschendes Plasma zwischen den sich beispielsweise gegenüberstehenden oder in nächster Nachbarschaft sich befindenden Elektroden mit der eingestellten Pulsfrequenz hin und her. Die sich in diesem Plasma befindenden Substrate erfahren so zusätzlich zur gerichteten Beschichtung durch die Elektroden noch eine zusätzliche Beschichtung aus dem bewegten Plasmavolumen, das heißt aus der Gasphase.

In einer vorteilhaften Ausführungsform der Erfindung wird das Tastverhältnis der Spannung, das heißt das zeitliche Verhältnis zwischen dem positiven und dem negativen Spannungswert, auf einen Wert von 1:1 gesetzt. Andere Tastverhältnisse sind ebenfalls möglich.

Es hat sich als vorteilhaft herausgestellt, einen Abstand zwischen zwei Elektroden von 60 cm vorzusehen. Vorzugsweise ist es auch möglich, den Abstand zwischen den Elektroden bis zu 2 m, insbesondere bis zu etwa 1 m zu wählen.

Vorzugsweise wird innerhalb der Prozeßkammer ein Druck von 1-5 x 10⁻³ mbar eingestellt, wobei als Prozeßgas Acetylen und Argon vorzugsweise in einem Verhältnis von 1:1 bis 10:1 verwendet werden.

Vorzugsweise lassen sich statt Acetylen auch andere Gase einsetzen, beispielsweise Methan für eine kohlenstoffhaltige Beschichtungen; Silane, beispielsweise Silan für siliziumhaltige Beschichtungen, oder Silizium-Organika wie HMDS, HMDS(O), HMDS(N), TMS oder Metallorganika für metallhaltige Schichtsysteme. Daneben sind weitere beliebige, dem Fachmann bekannte Gase einsetzbar, wie etwa Edelgase Ar, Kr, He oder weitere Reaktivgase wie O₂, N₂, NH₃ oder H₂. Es können selbstverständlich auch Mischungen der verschiedenen, oben beschriebenen Gase eingesetzt werden. In einer vorteilhaften Weiterbildung der Erfindung wird die mittlere Sputterleistung der einzelnen Elektroden getrennt voneinander geregelt. Alternativ können unterschiedliche Tastverhältnisse eingesetzt und genutzt werden. Damit läßt sich ein unterschiedlicher Bedeckungs- oder Abnutzungsgrad der einzelnen Elektroden berücksichtigen und damit die Prozeßsicherheit erhöhen. Des weiteren lassen sich Multilagen unterschiedlicher Stöchiometrie abscheiden, zum Beispiel CrN/Cr₂N oder iC(MeC)/(a-C:H), wobei Me: W, Ti, Cr, Ta, etc. Es ist weiterhin möglich möglich, Schichten und Schichtsysteme mit stetig oder unstetig variierter Zusammensetzung abzuscheiden. Durch eine Steigerung des Reaktivgasflusses ist es etwa möglich, die Schichzusammensetzung zu variieren, beispielsweise von Me-C bis zu deutlich metallärmeren bis hin zu metallfreien Kohlenstoffschichten.

Ein weiterer Vorteil der Verwendung einer bipolaren, vorzugsweise rechteckförmigen Sputterspannung ist darin zu sehen, daß der Abstand zwischen den beiden Elektroden vergrößert werden kann, so daß sich über ein größeres Volumen beschichten läßt. Je nach Abstand ist dabei eine entsprechende Pulsfrequenz festzulegen.

In einer vorteilhaften Weiterbildung der Erfindung wird die Beschichtung bei einer Temperatur von weniger als 200° C durchgeführt.

In einer weiteren vorteilhaften Ausführungsform der Erfindung werden die Elektroden so angeordnet, daß sie einen Winkel von 0° bis 180°, vorzugsweise von 60° oder 180° einschließen.

In einer weiteren vorteilhaften Ausführungsform werden als Elektroden handelsübliche Magnetron-Sputterkathoden, also mit einem Magnetsystem versehene Kathoden eingesetzt. Die Geometrie der Elektroden kann planar oder gekrümmt bzw. zylinderförmig gestaltet sein.

In einer weiteren vorteilhaften Ausführungsform werden als Elektroden Hohlkathoden eingestzt, wobei sowohl solche, die punktförmige, als auch solche, die linienfömige als auch solche, die flächige Abstrahlcharakteristiken zeigen, Verwendung finden können.

In einer weiteren vorteilhaften Ausführungsform werden als Elektroden gegenüber der Kammerwand elektrisch isolierte ECR-Elektroden genutzt, die mit einer elektrischen Spannung beaufschlagt werden können. Das Plasma an den ECR-Elektroden wird mit Mikrowellenstrahlung zusätzlich angeregt.

In einer weiteren vorteilhaften Ausführungsform werden als Elektroden gegenüber der Kammerwand elektrisch isolierte Mittelfrequenz- oder Hochfrequenz-Elektroden genutzt, die mit einer elektrischen Wechselspannung gegen Erdpotential betrieben werden und je Elektrode ein Plasma brennen läßt. Zusätzlich wird eine weitere Wechselspannung zwischen den Elektroden angelegt, die das Plasma zwischen den Elektroden bewegt und den Raum zwischen den Elektroden ausfüllt.

Die Elektroden können sowohl als magnetfeldfreie Dioden als auch als Magnetronelektroden ausgebildet werden. Das Magnetfeld kann hierbei sowohl balanciert als auch unbalanciert gestaltet werden. Unbalancierte Magnetfelder an den Elektroden lassen sich sowohl durch eine entsprechende Konfiguration von Permanetmagneten als auch durch elektromagnetische Spulen, die um oder nahe an den Elektroden positioniert werden, erzeugen. In einer vorteilhaften Ausführung erlaubt der unbalancierte Betrieb eine Erhöhung der Plasmadichte und eine stärkere Volumenausdehnung der einzelnen Elektrodenplasmen.

In einer weiteren vorteilhaften Ausführungsform der Erfindung wird die Prozeßkammer auf Erdpotential gelegt.

Besonders vorteilhaft läßt sich das erfindungsgemäße Verfahren in einer Batchanlage, in einer Durchlaufanlage oder in einer Schüttgutanlage einsetzen. Hierbei können die zu beschichtenden Teile vor den Beschichtungsquellen fest ruhen oder sich bewegen, d. h. sich an den Quellen vorbeibewegen bzw. rotieren.

Die Gase können in Form einer Gasmischung oder getrennt oder in unterschiedlichen Mischungen an unterschiedlichen Stellen der Beschichtungsanlage eingespeist werden. Es kann von Vorteil sein, die inerten Gase wie z.B. Argon nahe der Elektroden und die Reaktivgase wie Kohlenstoff- bzw. Siliziumbasierte Gase nahe der Substrate in die Beschichtungskammer einzuleiten, um die Abscheiderate und Schichtqualität zu beeinflussen.

Das Verfahren erlaubt die Kombination der Elektroden mit weiteren Plasma- und Beschichtungsquellen wie etwa zusätzlichen Sputterquellen, Bogenquellen, Hohlkathodenquellen, Mikrowellenquellen, RF-Quellen oder anodisch geschaltete Elektrodenflächen. Damit wird es möglich, die Plasmabedingungen wie etwa Elektronendichte, Anregungsgrad oder Elektronentemperatur zu variieren, die Raumausdehnung zu beieinflussen und die Abscheideraten und Schichteigenschaften zu beeinflussen. Es kann beispielsweise die Stärke des Ionenbeschusses, die Ionenenergie und die Art der abzuscheidenden Teilchen beeinflusst werden. Über zusätzliche Beschichtungsquellen können weitere Elemente in den Prozeß und damit in die Schicht eingebracht werden. Dies ermöglicht etwa Kompositionsänderungen oder Dotierungen. Als weiterer Vorteil ist eine Beeinflussung und Erhöhung der Abscheiderate dadurch möglich.

Es ist weiterhin vorteilhaft, den Ionenbeschuß der Substrate während der Abscheidung zu beeinflussen und Energie gezielt in den Wachstumsprozeß einzubringen. Damit können Schichteigenschaften wie etwa Härte oder Elastizität oder Zusammensetzung gesteuert werden. Dies wird durch Anlegen einer Bias-Spannungsversorgung an die Substrate realisiert. Im Falle elektrisch leitfähiger Schichten kann dies durch Anlagen einer Gleich-, Wechsel- oder bipolar gepulsten Spannung geschehen. Für elektrisch isolierende Schichten ist eine Wechselspannung von Vorteil, beispielsweise eine Mittelfrequenz- oder Hochfrequenzspannung oder eine gepulste bipolare Spannung.

Es ist weiterhin vorteilhaft, die Höhe und Frequenz der Biasspannung derart zu wählen, daß das Anlegen der Biasunterstützung die Aufwachsrate der Schichten steigert. Die Steigerung der Aufwachsraten wird insbesondere für kohlenstoff- und siliziumbasierte Schichten beobachtet.

Es ist weiterhin vorteilhaft, bei Verwendung eines Wechselfrequenz- oder gepulsten Bias die Taktfrequenz und Phase von Bias und Elektrodenversorgungen aufeinander abzustimmen. Dies beeinflußt die Aufwachsraten, die Morphologie und Härte der Schichten als auch das Temperaturniveau der Substrate während des Beschichtungsprozesses.

### Zeichnung

Die Erfindung wird nun anhand eines Ausführungsbeispiels mit Bezug auf die Zeichnung näher beschrieben. Dabei zeigen:
- Figur 1: eine schematische Darstellung einer Sputter-Anlage, und
- Figur 2: ein Diagramm, bei dem für unterschiedliche Verfahren (DC-Sputtern; erfindungsgemäßes Sputtern) die Abscheidungsrate in µm/h über dem Gasfluß angegeben sind.

### Ausführungsbeispiel

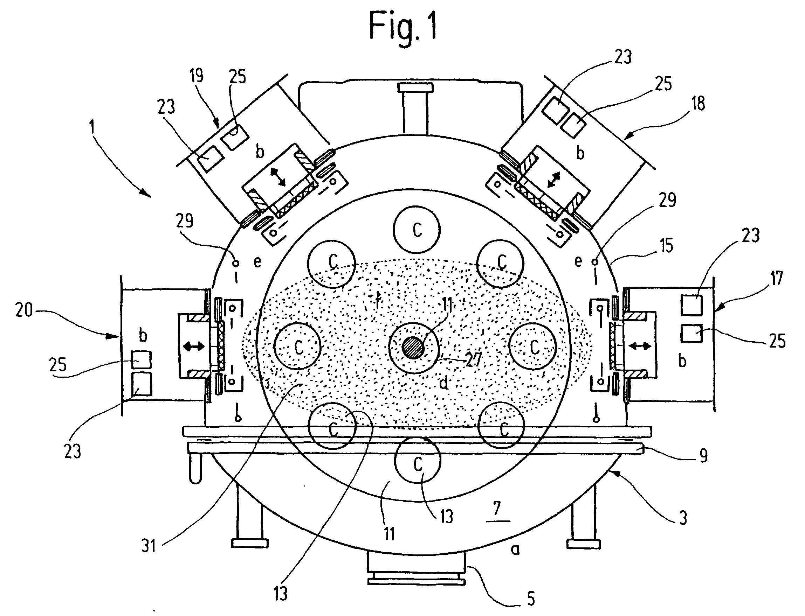

In Figur 1 ist eine Magnetron-Sputteranlage 1 dargestellt, die zur Beschichtung von Substraten eingesetzt wird. Der grundsätzliche Aufbau einer solchen Magnetron-Sputteranlage ist bekannt, weshalb im folgenden auf eine detallierte Beschreibung der einzelnen Komponenten verzichtet wird.

Die Magnetron-Sputteranlage umfaßt einen mit einem Erd- oder Massepotential verbundenen Rezipienten 3, der über ein Ansatzrohr 5 verfügt, das mit einer - nicht dargestellten- Vakuumpumpe verbunden ist. Der Rezipient 3 umschließt eine Prozeßkammer 7, die mittels der Vakuumpumpe evakuierbar ist. Der Rezipient 3 verfügt über eine nur schematisch dargestellte Öffnungsmechanik 9, die ein Öffnen des Rezipienten und damit ein Beladen der Prozeßkammer mit den zu beschichtenden Substraten ermöglicht.

Innerhalb der Prozeßkammer 7 ist eine Drehvorrichtung 11 vorgesehen, die eine Anzahl von Substraten 13, im vorliegenden Ausführungsbeispiel acht, aufnimmt und eine Drehung der Substrate um eine Drehachse ermöglicht, die senkrecht zur Zeichnungsebene verläuft.

In einer -in Draufsicht- kreisförmigen Wandung 15 des Rezipienten 3 sind beabstandet zueinander Sputter-Elektrodeneinheiten 17 bis 20 angeordnet. Alle -im vorliegenden Ausführungsbeispiel vier- Sputter-Elektrodeneinheiten 17 bis 20 sind identisch aufgebaut und umfassen jeweils eine Elektrode und ein Magnetsystem. Darüber hinaus sind die Elektroden jeder Sputter-Elektrodeneinheit 17 bis 20 mit einer Spannungsversorgung 23 versehen, die ihrerseits mit einer Steuerungseinrichtung 25 verbunden ist. Sowohl die Spannungsversorgung 23 als auch die Steuerungseinrichtung 25 sind der Übersichtlichkeit wegen lediglich schematisch dargestellt. Selbstverständlich ist es auch denkbar, für die im vorliegenden Ausführungsbeispiel vier Sputter-Elektrodeneinheiten 17 bis 20 eine gemeinsame Spannungsversorgung 23 und eine gemeinsame Steuerungseinrichtung 25 vorzusehen.

Die Ausrichtung der Sputter-Elektrodeneinheiten 17 bis 20 erfolgt zu einem Mittelpunkt M des Rezipienten 3, wobei die vorgenannte Drehachse der Drehvorrichtung 11 durch diesen Mittelpunkt verläuft. Der Winkel, der zwischen den SputterElektrodeneinheiten 17, 18 beziehungsweise 18, 19 beziehungsweise 19, 20 aufgespannt wird, beträgt etwa 60°. Damit ist der zwischen den Sputter-Elektrodeneinheiten 17, 20 gebildete Winkel 180°. Selbstverständlich sind auch andere Winkelkombinationen denkbar.

Der Abstand der sich gegenüberliegenden Sputter-Elektrodeneinheiten 17 und 20 beträgt im vorliegenden Ausführungsbeispiel etwa 60 cm, was auch in etwa dem Durchmesser des Rezipienten entspricht. Der Abstand der Sputter-Elektrodeneinheiten läßt sich jedoch in einem weiten Bereich variieren, so daß auch Abstände von 1 m bis 2 m ohne weiteres möglich sind.

Die Magnetron-Sputteranlage 1 verfügt zusätzlich über einen Mikrowellengenerator 27, der in Figur 1 rein schematisch dargestellt ist. Vorzugsweise werden die Mikrowellen des Mikrowellengenerators im Bereich des Mittelpunkts M des Rezipienten 3 in die Prozeßkammer 7 eingekoppelt. In ener anderen Ausführung werden Mikrowellen vom Rand des Reaktors aus eingekoppelt. Es ist auch denkbar, andere Plasma- oder Teilchenquellen zusätzlich einzusetzen.

Des weiteren verfügt die Magnetron-Sputteranlage 1 über ein Gaszuführungssystem 29, das ebenfalls rein schematisch dargestellt ist und die Aufgabe hat, die Prozeßkammer 7 mit einem Prozeßgas zu befüllen. Dieses Prozeßgas enthält das auf den Substraten abzuscheidende Material, wobei die vorzugsweise aus Edelstahl oder einem anderen Metall oder einer Metallverbindung wie Ti, Cr, W, WC gefertigten Elektroden der Sputter-Elektrodeneinheiten 17 bis 20 im Betrieb der Anlage nicht oder nahezu nicht zerstäubt werden.

Die Sputter-Anlage 1 arbeitet nun wie folgt:

Sobald die Substrate 13 in die Prozeßkammer 7 eingebracht sind, wird diese evakuiert.

Es kann vorteilhaft sein, die Prozeßkammer und die darin befindlichen Substrate auf eine gewünschte Prozeßtemperatur aufzuheizen. Weiterhin kann hierdurch eine Desorption der Oberflächen bewirkt und eine Reduktion der Pumpzeit erreicht werden.

Es kann eine Reinigung der Substratoberflächen durch Beschuß mit Ionen ausreichender Energie vorgenommen werden. Dies kann auf verschiedene Weisen erfolgen, die dem Fachmann bekannt sind und in der Literatur beschrieben sind.

Zur Erhöhung der Haftung zwischen Substrat und Beschichtung kann es vorteilhaft sein, zunächst eine haftungsvermittelnde Zwischenschicht aufzubringen. Die Art dieser Zwischenschicht ist abhängig von Substrat und Hauptschicht. Sie kann sowohl über PVD- als auch CVD-Prozesse aufgebracht werden. Dies kann entweder durch Verwendung der in der Zeichnung dargestellten Elektroden erfolgen, oder aber über zusätzlich, nicht dargestellte Quellen. Die haftvermittelnde Schicht kann mit konstanter oder variabler Zusammensetzung abgeschieden werden und ihrerseits wieder aus Einzelschichten zusammengesetzt sein.

Danach werden zur Abscheidung der eigentlichen Hauptschicht die Prozeßgase Acetylen und Argon über das Gaszuführungssystem 29 eingebracht, wobei ein Druck von 1-5 x 10⁻³ mbar, insbesondere etwa 3 x 10⁻³ mbar gewünscht ist. Das Verhältnis der beiden Gase Argon/Acetylen beträgt 1 bis 0,1.

Zum Start des Beschichtungsverfahrens werden beispielsweise bei einem Zwei-Elektrodenbetrieb die beiden sich gegenüberstehenden Sputter-Elektrodeneinheiten 17 und 20 aktiviert. Hierzu werden die Elektroden der beiden Sputter-Elektrodeneinheiten 17, 20 mit einer bipolaren rechteckförmigen gepulsten Spannung beaufschlagt, wobei die Impulsfrequenz bevorzugt im Bereich von 1 kHz bis 1 Mhz liegt. Vorzugsweise sind die Zeitabschnitte, in denen die Elektroden mit einer positiven und mit einer negativen Spannung beaufschlagt sind, gleich lang. Damit ergibt sich also ein Tastverhältnis der rechteckförmigen gepulsten Spannung von 1:1.

Durch die bipolare Spannung arbeiten die Elektroden der beiden Sputter-Elektrodeneinheiten 17, 20 sowohl als Kathoden als auch als Anoden. Mittels der Steuerungseinrichtungen 25 werden die Spannungsversorgungen 23 der beiden Sputter-Elektrodeneinheiten 17, 20 so zueinander synchronisiert, daß zur gleichen Zeit jeweils nur eine der beiden Elektroden als Kathode arbeitet.

Die Höhe der Spannung wird so eingestellt, daß sich eine Elektrodenleistung von 4 kW im zeitlichen Mittel ergibt. Das heißt, daß pro Impuls eine Leistung von 8 kW vorzusehen ist.

Die beiden Sputter-Elektrodeneinheiten 17, 20 setzen das einströmende Prozeßgas in ein Plasma 31 um, das rein schematisch als Plasmawolke dargestellt ist, die sich zwischen den beiden Sputter-Elektrodeneinheiten 17, 20 erstreckt.

Wird beispielsweise bei mit Spannung versorgten Elektroden ein hoher Fluß eines kohlenstoffhaltigen Prozeßgases in die Prozeßkammer 7 eingelassen, bildet sich bei entsprechend eingestelltem Fluß eine Schicht auf den Elektroden, die diese vollständig bedeckt. Man spricht in diesem Fall von einer vollständigen Vergiftung der Elektroden. Obgleich die Elektroden nunmehr isoliert sind, ist ein fortlaufender Betrieb durch die Verwendung einer gepulsten Spannung weiterhin gewährleistet. Eine Vergiftung der Elektroden tritt beispielsweise bei Gasverhältnissen Acetylen/Argon größer als 3 ein.

Die bipolare Spannungsversorgung und die entsprechende Synchronisation der beiden bipolaren Spannungen sorgt dafür, daß am Ende eines Spannungsimpulses das Plasma erlischt während es an der anderen gegenüberliegenden Elektrode neu gezündet wird. Das Zünden des Plasmas an der aktiv werdenden Elektrode wird dadurch erleichtert, daß Ladungsträger aus dem sterbenden Plasma der gegenüberliegenden Elektrode vorhanden sind.

Um eine optimale Beschichtungsrate zu erreichen, werden die Parameter der Anlage so gewählt, daß die räumlich weitestgehend stabilen, isolierten Plasmen vor den jeweiligen Elektroden nicht kontinuierlich entstehen und verlöschen, sondern daß das Plasma von der gerade ausgeschalteten Kathode zur inbetriebgehenden Kathode gezogen wird. Hierfür müssen die Impulsfrequenz, die lonenlaufzeit im Plasma und die Elektrodenabstände aufeinander abgestimmt sein. In diesem Fall wandert das nicht verlöschende Plasma zwischen den sich gegenüberliegenden Elektroden mit der eingestellten Impulsfrequenz hin und her. Die sich im Weg des Plasmas befindenden Substrate 13 erfahren so zusätzlich zur gerichteten Beschichtung durch die Elektroden noch eine zusätzliche Beschichtung aus dem bewegten Plasmavolumen.

Um die Beschichtungsrate weiter zu erhöhen, lassen sich über den Mikrowellengenerator 27 Mikrowellen in die Prozeßkammer 7 einkoppeln, die für eine zusätzliche Anregung des Prozeßgases sorgen. Diese Anregung bewirkt sowohl direkt eine Beschichtung der Substrate als auch eine Beschichtung der Elektroden. Durch ein zusätzliches Magnetfeld kann der ECR-Effekt genutzt werden, die Plasmadichte erhöht und das Plasma bei niedrigeren Drücken betrieben werden.

Besonders vorteilhaft ist es, die Steuerungseinrichtungen 25 getrennt voneinander zu betreiben, so daß die Spannungsversorgungen und damit die jeweilige Elektrodenleistung unabhängig voneinander eingestellt werden können. Damit lassen sich beispielsweise unterschiedliche Abnutzungsgrade der Elektroden ausgleichen. Es ist dadurch auch möglich, die Zusammensetzung der durch die einzelnen Elektroden abgeschiedenen Schichten zu beeinflussen. Auf diese Weise ist es möglich, Mehrfach- und Multilagen aus alternierenden Einzelschichten aufzubauen.

Das Verfahren wird hauptsächlich dafür eingesetzt, Oberflächen zu beschichten, um deren Widerstandsfähigkeit gegen Verschleiß zu erhöhen. So werden beispielsweise metallarme oder metallfreie amorphe wasserstoffhaltige Kohlenstoffschichten abgeschieden. Hierbei wird bei bipolar gepulsten Sputter-Elektroden der Fluß eines kohlenstoffhaltigen Prozeßgases so erhöht, daß eine vollständige Bedeckung der Elektroden mit Kohlenstoff resultiert. Die Beschichtungsrate wird im Vergleich zu einer nur teilweise bedeckten Elektrode stark erhöht, während sich der Anteil des in die Schicht eingebauten Metalls verringert, gegebenenfalls auf Null sinkt.

Durch das beschriebene Verfahren ist eine Schichtabscheidung bei hohen Raten möglich. Umgekehrt ist es auch möglich, eine niedrigere Beschichtungsrate als die maximal mögliche zu wählen und damit die Beschichtungstemperatur abzusenken.

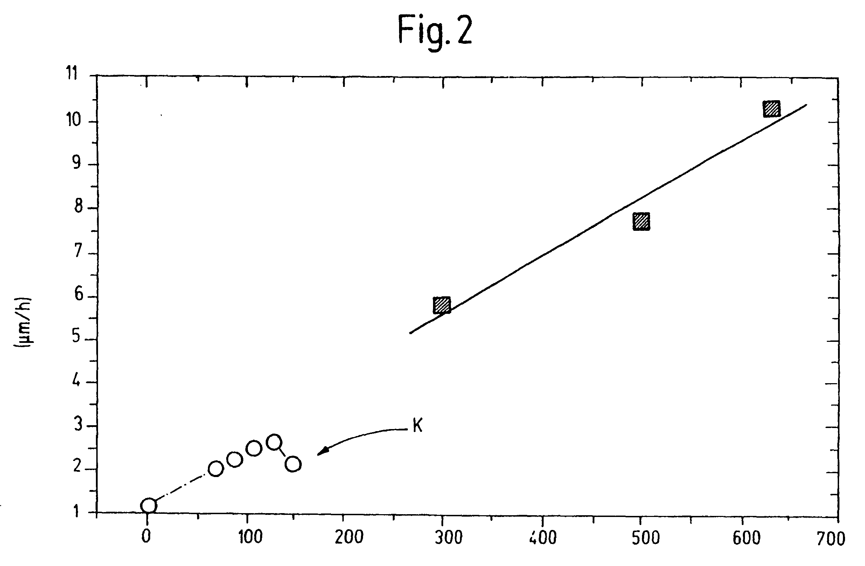

Zur Verdeutlichung der Beschichtungsraten zeigt Figur 2 ein Diagramm, bei dem auf der X-Achse der Gasfluß und auf der Y-Achse die Abscheidungsrate in µm/h aufgetragen sind. Zu erkennen ist, daß die Abscheidungsraten bekannter Verfahren (DC-Sputtern; gekennzeichnet durch o) im Bereich von 0 bis 4 liegen, während die Abscheidungsraten mit dem erfindungsgemäßen Verfahren (gekennzeichnet durch ) im Bereich von 4 bis 12 gemessen wurden. Ein Betrieb des herkömmlichen Verfahrens bei höheren Gasflüssen ist praktisch nicht möglich, da die Betriebsstabilität dann verloren geht. In Figur 2 ist für das herkömmliche Verfahren der Punkt mit einem K gekennzeichnet, bei dem eine Vergiftung der Elektroden eintritt mit der Folge einer abnehmenden Beschichtungsrate.

Ein weiteres Beispiel betrifft die Verwendung von mehr als 2 Elektroden und anderen Konfigurationen. Es sind prinzipiell unterschiedlichste Anordnungen denkbar. Für eine geradzahlige Anordnung beispielsweise können 4 Elektroden verwendet werden, von denen die direkt benachbarten einen Winkel von jeweils 90° zueinander aufweisen, oder etwa 6 mit einem Winkel von 60°, etc. Diese Elektroden können paarweise oder gruppenweise gegeneinander gepulst werden.

## Patentansprüche

1. Verfahren zur Beschichtung von Oberflächen mittels einer Anlage, die zumindest zwei beabstandet zueinander und innerhalb einer Prozesskammer angeordnete Sputterelektroden und einen Einlass für ein Prozessgas aufweist, wobei mindestens ein zu beschichtendes Substrat zwischen den mindestens zwei Elektroden angeordnet wird, die Elektroden mit einer bipolar gepulsten Spannung beaufschlagt werden, derart, dass sie alternierend als Kathoden und Anoden betrieben werden und zur gleichen Zeit jeweils nur eine von zwei sich im Wesentlichen einander gegenüberstehenden Elektroden als Kathode arbeitet, die Frequenz der Spannung zwischen 1 kHz und 1 MHz eingestellt wird und die Betriebsparameter so gewählt werden, dass die Elektroden im Betrieb zumindest bereichsweise von einem Beschichtungsmaterial bedeckt werden.

2. Verfahren nach Anspruch 1, **dadurch gekennzeichnet, daß** eine starke Vergiftung der Elektrodenoberflächen durch Reaktivgaseinlaß bewirkt wird.

3. Verfahren nach Anspruch 1 oder 2, **dadurch gekennzeichnet, daß** der Reaktivgasfluß über den Wert hinaus erhöht wird, der einer vollständigen Bedekkung entspricht.

4. Verfahren nach einem der Ansprüche 1 bis 3, **dadurch gekennzeichnet, daß** das Kammervolumen zwischen den Elektroden mit Plasma ausgefüllt wird, insbesondere desjenigen Teils, in dem sich die Susbtrate befinden, insbesondere mit einer variierenden Pulsfrequenz.

5. Verfahren nach einem der vorhergehenden Ansprüche, **dadurch gekennzeichnet, daß** als Spannung eine im wesentlichen rechteckförmige Spannung gewählt wird.

6. Verfahren nach einem der vorhergehenden Ansprüche, **dadurch gekennzeichnet, daß** das Tastverhältnis der Spannung (duty cycle) eingestellt werden kann, insbesondere auf einen Wert von etwa 1:1.

7. Verfahren nach einem der vorhergehenden Ansprüche, **dadurch gekennzeichnet, daß** der Abstand zwischen den Elektroden bis zu 2m, vorzugsweise 60 cm bis 1m beträgt.

8. Verfahren nach einem der vorhergehenden Ansprüche, **dadurch gekennzeichnet, daß** als Prozeßgas ein Edelgas und ein Reaktivgas eingesetzt werden, wobei als Edelgas vorzugsweise Argon, oder Ar, Kr oder He, und als Reaktivgas vorzugsweise Methan oder Acetylen für kohlenstoffhaltige Schichten, oder vorzugsweise Silane, insbesondere Silan, Si-Organika wie HMDS, HMDS(O), HMDS(N), TMS oder Metallorganika für Si-haltige Schichten verwendet werden.

9. Verfahren nach einem der vorherigen Ansprüche, **dadurch gekennzeichnet, daß** ein weiteres Gas als Prozeßgas hinzugefügt wird, insbesondere N₂, H₂ oder O₂.

10. Verfahren nach einem der vorherigen Ansprüche, **dadurch gekennzeichnet, daß** Gase als Mischung in die Prozeßkammer eingelassen werden, oder in unterschiedlichen Mischungen, an einer Einlaßstelle, oder an unterschiedlichen Einlaßstellen.

11. Verfahren nach einem der vorhergehenden Ansprüche, **dadurch gekennzeichnet, daß** der Druck innerhalb der Prozeßkammer 1-5 x 10⁻³ mbar beträgt.

12. Verfahren nach Anspruch 8, **dadurch gekennzeichnet, daß** das Verhältnis der Gasflüsse von Edelgas und Reaktivgas beliebig gewählt wird, insbesondere im Bereich von 1 bis 0,1.

13. Verfahren nach Anspruch 8, **dadurch gekennzeichnet, daß** statt Acetylen als Prozeßgas Methan Silan eingesetzt wird.

14. Verfahren nach einem der vorhergehenden Ansprüche, **dadurch gekennzeichnet, daß** eine Mikrowellenstrahlung in die Prozeßkammer eingekoppelt wird.

15. Verfahren nach einem der vorhergehenden Ansprüche, **dadurch gekennzeichnet, daß** die Leistung der Elektroden getrennt voneinander, vorzugsweise geregelt eingestellt wird.

16. Verfahren nach einem der vorhergehenden Ansprüche, **dadurch gekennzeichnet, daß** die Beschichtung bei einer Temperatur durchgeführt wird, die kleiner oder gleich 200°C ist.

17. Verfahren nach einem der vorhergehenden Ansprüche, **dadurch gekennzeichnet, daß** die Elektroden so angeordnet werden, daß sie einen Winkel von 0°-180°, vorzugsweise 60°, 90°, 180° einschließen.

18. Verfahren nach einem der vorhergehenden Ansprüche, **dadurch gekennzeichnet, daß** als Elektroden Magnetron-Sputterkathoden eingesetzt werden.

19. Verfahren nach Anspruch 13, **dadurch gekennzeichnet, daß** Kathoden planar, oder zylindrisch, oder gekrümmt gestaltet sind.

20. Verfahren nach einem der vorhergehenden Ansprüche, **dadurch gekennzeichnet, daß** als Elektroden Mittelfrequenz- oder Hochfrequenzelektroden, oder ECR-Elektroden, oder Hohlkathoden eingesetzt werden.

21. Verfahren nach einem der vorhergehenden Ansprüche, **dadurch gekennzeichnet, daß** die Prozeßkammer auf Erdpotential gelegt wird.

22. Verfahren nach einem der vorhergehenden Ansprüche, **dadurch gekennzeichnet, daß** eine kohlenstoffhaltige Schicht, insbesondere eine amorphe wasserstoffhaltige Kohlenstoffschicht, mit beliebigem Metallgehalt abgeschieden wird.

23. Verfahren nach einem der Ansprüche 1 bis 21, **dadurch gekennzeichnet, daß** eine siliziumhaltige Schicht abgeschieden wird, insbesondere eine amorphe, wasserstoffhaltige Siliziumschicht, mit beliebigem Metallgehalt.

24. Verfahren nach einem der vorhergehenden Ansprüche, **dadurch gekennzeichnet, daß** die zu behandelnden oder zu beschichtenden Teile auf ein negatives Bias-Potential gelegt sind.

25. Verfahren nach Anspruch 24, **dadurch gekennzeichnet, daß** der Bias gepulst ist.

26. Verfahren nach Anspruch 24, **dadurch gekennzeichnet, daß** der Bias ein HF-Bias (kHz, MHz) ist.

27. Verfahren nach einem der vorhergehenden Ansprüche, **dadurch gekennzeichnet, daß** die Beschichtung auf stehenden oder bewegten Substraten durchgeführt wird.

28. Verfahren nach einem der vorhergehenden Ansprüche, **dadurch gekennzeichnet, daß** zusätzliche Plasma- und Teilchenquellen verwendet werden, vorzugsweise Mirkowelle, ECR-Mikrowelle, Hohlhathode, Bogenquelle und/oder Verdampfer.

29. Verwendung des Verfahrens nach einem der Ansprüche 1 bis 28 in einer Batchanlage oder einer Durchlaufanlage oder einer Schüttgutanlage.

## Claims

1. Method for coating surfaces by means of an installation which has at least two sputtering. electrodes which are arranged at a distance from one another and inside a process chamber, and an inlet for a process gas, at least one substrate which is to be coated being arranged between the at least two electrodes, a bipolar pulsed voltage being applied to the electrodes, in such a manner that they are operated alternately as cathodes and anodes, and, at the same time, in each case only one of two electrodes which are substantially opposite one another acting as cathode, the frequency of the voltage being set at between 1 kHz and 1 MHz, and the operating parameters being selected in such a way that the electrodes, in operation, are covered by a coating material at least in some areas.

2. Method according to Claim 1, **characterized in that** considerable poisoning of the electrode surfaces is effected by the admission of reactive gas.

3. Method according to Claim 1 or 2, **characterized in that** the flow of reactive gas is increased to above the level which corresponds to complete coverage.

4. Method according to one of Claims 1 to 3, **characterized in that** the chamber volume between the electrodes is filled with plasma, in particular that part in which the substrates are located, in particular with a varying pulse frequency.

5. Method according to one of the preceding claims, **characterized in that** a substantially square-wave voltage is selected as the voltage.

6. Method according to one of the preceding claims, **characterized in that** the duty cycle can be adjusted, in particular to a value of approximately 1:1.

7. Method according to one of the preceding claims, **characterized in that** the distance between the electrodes is up to 2 m, preferably 60 cm to 1 m.

8. Method according to one of the preceding claims, **characterized in that** the process gas used is a noble gas and a reactive gas, the noble gas used preferably being argon, or Ar, Kr or He, and the reactive gas used preferably being methane or acetylene for carbon-containing layers, or preferably silanes, in particular silane, Si organics, such as HMDS, HMDS(O), HMDS(M), TMS, or metal organics for Si-containing layers.

9. Method according to one of the preceding claims, **characterized in that** a further gas is added as process gas, in particular N₂, H₂ or O₂.

10. Method according to one of the preceding claims, **characterized in that** gases are admitted to the process chamber as a mixture, or in different mixtures, at one inlet point, or at different inlet points.

11. Method according to one of the preceding claims, **characterized in that** the pressure inside the process chamber is 1-5 x 10⁻³ mbar.

12. Method according to Claim 8, **characterized in that** the ratio of the flow of noble gas to the flow of reactive gas is selected as desired, in particular in the range from 1 to 0.1.

13. Method according to Claim 8, **characterized in that** instead of acetylene the process gas used is methylsilane.

14. Method according to one of the preceding claims, **characterized in that** microwave radiation is introduced into the process chamber.

15. Method according to one of the preceding claims, **characterized in that** the power of the electrodes is set, preferably controlled, separately from one another.

16. Method according to one of the preceding claims, **characterized in that** the coating is carried out at a temperature which is less than or equal to 200°C.

17. Method according to one of the preceding claims, **characterized in that** the electrodes are arranged in such a way that they include an angle of 0°-180°, preferably 60°, 90° or 180°.

18. Method according to one of the preceding claims, **characterized in that** the electrodes used are magnetron sputtering cathodes.

19. Method according to Claim 18, **characterized in that** cathodes are of planar or cylindrical or curved configuration.

20. Method according to one of the preceding claims, **characterized in that** the electrodes used are medium-frequency or high-frequency electrodes, or ECR electrodes, or hollow cathodes.

21. Method according to one of the preceding claims, **characterized in that** the process chamber is applied to earth potential.

22. Method according to one of the preceding claims, **characterized in that** a carbon-containing layer, in particular an amorphous hydrogen-containing carbon layer, with any desired metal content is deposited.

23. Method according to one of Claims 1 to 21, **characterized in that** a silicon-containing layer is deposited, in particular an amorphous, hydrogen-containing silicon layer, with any desired metal content.

24. Method according to one of the preceding claims, **characterized in that** the parts which are to be treated or coated are applied to a negative bias potential.

25. Method according to Claim 24, **characterized in that** the bias is pulsed.

26. Method according to Claim 24, **characterized in that** the bias is an HF bias (kHz, MHz).

27. Method according to one of the preceding claims, **characterized in that** the coating is carried out on stationary or moving substrates.

28. Method according to one of the preceding claims, **characterized in that** additional plasma and particle sources are used, preferably microwave, ECR microwave, hollow cathode, arc source and/or vaporizer.

29. Use of the method according to one of Claims 1 to 28 in a batch installation or a continuous installation or a bulk material installation.

## Revendications

1. Procédé de revêtement de surface d'une installation comportant au moins deux électrodes de pulvérisation, distantes l'une de l'autre dans un réacteur et une entrée pour un gaz de procédé, au moins l'un des supports à revêtir étant placé entre au moins deux électrodes et les électrodes recevant une tension bipolaire pulsée de façon à fonctionner en alternance comme cathode et anode et en même temps seulement l'une des deux électrodes essentiellement en regard, fonctionne comme cathode, et la fréquence de la tension est comprise entre 1 kHz et 1 MHz et les paramètres de fonctionnement sont choisis pour que les électrodes soient au moins partiellement recouvertes d'une matière de recouvrement pendant le fonctionnement.

2. Procédé selon la revendication 1,
**caractérisé en ce qu'**
un fort empoisonnement de la surface des électrodes est produit par une entrée de gaz de réaction.

3. Procédé selon la revendication 1 ou 2,
**caractérisé en ce que**
le flux de gaz de réaction est augmenté au-delà de la valeur qui correspond au recouvrement complet.

4. Procédé selon l'une quelconque des revendications 1 à 3,
**caractérisé en ce que**
le volume de la chambre entre les électrodes est rempli de plasma notamment les parties du volume dans lequel se trouvent les supports, en particulier avec une fréquence d'impulsions variable.

5. Procédé selon l'une des revendications précédentes,
**caractérisé en ce que**
la tension est une tension essentiellement rectangulaire.

6. Procédé selon l'une quelconque des revendications précédentes,
**caractérisé en ce que**
le rapport de travail de la tension est réglable notamment à une valeur de 1/1.

7. Procédé selon l'une quelconque des revendications précédentes,
**caractérisé en ce que**
la distance entre les électrodes peut aller jusqu'à 2 m et elle est de préférence comprise entre 60 cm et 1 m.

8. Procédé selon l'une quelconque des revendications précédentes,
**caractérisé en ce que**
le gaz de procédé est un gaz noble ou un gaz de réaction et le gaz noble est de préférence de l'argon ou Ar, Kr ou He et le gaz réactif est de préférence du méthane ou de l'acétylène pour les couches à teneur en carbone ou de préférence des silanes notamment du silane, des organosilanes tels que HMDS, HMDS(O), HMDS(N), TMS ou des composés organiques métalliques pour des couches contenant le silicium Si.

9. Procédé selon l'une quelconque des revendications précédentes,
**caractérisé en ce qu'**
on ajoute un autre gaz comme gaz de procédé notamment N₂, H₂, O₂.

10. Procédé selon l'une quelconque des revendications précédentes,
**caractérisé en ce que**
les gaz sont introduits à l'état de mélange dans le réacteur ou selon des rapports différents à un point d'admission ou en des points d'admission différents.

11. Procédé selon l'une quelconque des revendications précédentes,
**caractérisé en ce que**
la pression dans le réacteur est de 1-5 x 10⁻³ mbar.

12. Procédé selon la revendication 8,
**caractérisé en ce que**
le rapport des débits de gaz noble et de gaz de réaction est choisi de manière quelconque notamment dans la plage comprise entre 1 et 0,1.

13. Procédé selon la revendication 8,
**caractérisé en ce qu'**
à la place d'acétylène comme gaz de procédé, on utilise du méthane silane.

14. Procédé selon l'une quelconque des revendications précédentes,
**caractérisé en ce qu'**
on injecte dans le réacteur un rayonnement de micro-ondes.

15. Procédé selon l'une quelconque des revendications précédentes,
**caractérisé en ce qu'**
on règle la puissance des électrodes, séparément l'une de l'autre, de préférence par régulation.

16. Procédé selon l'une quelconque des revendications précédentes,
**caractérisé en ce qu'**
on effectue le revêtement à une température inférieure ou égale à 200°C.

17. Procédé selon l'une quelconque des revendications précédentes,
**caractérisé en ce que'**
on dispose les électrodes pour qu'elles forment un angle de 0°-180° et de préférence un angle de 60°, 90°, 180°.

18. Procédé selon l'une quelconque des revendications précédentes,
**caractérisé en ce qu'**on utilise comme électrodes, des cathodes de pulvérisation de magnétron.

19. Procédé selon la revendication 18,
**caractérisé en ce que**
les cathodes sont planes, cylindriques ou courbes.

20. Procédé selon l'une quelconque des revendications précédentes,
**caractérisé en ce que**
les électrodes sont des électrodes de fréquence moyenne ou de haute fréquence ou des électrodes ECR ou des cathodes creuses.

21. Procédé selon l'une quelconque des revendications précédentes,
**caractérisé en ce que**
le réacteur est mis au potentiel de la masse.

22. Procédé selon l'une quelconque des revendications précédentes,
**caractérisé en ce qu'**
une couche contenant du carbone notamment une couche de carbone à hydrogène amorphe, est déposée avec une teneur en métal quelconque.

23. Procédé selon l'une quelconque des revendications 1 à 21,
**caractérisé en ce qu'**
on dépose une couche contenant du silicium notamment une couche de silicium amorphe contenant de l'hydrogène, avec une teneur quelconque en métal.

24. Procédé selon l'une quelconque des revendications précédentes,
**caractérisé en ce que**
les pièces à traiter ou à revêtir sont mises à un potentiel de polarisation négatif.

25. Procédé selon la revendication 24,
**caractérisé en ce que**
la polarisation est pulsée.

26. Procédé selon la revendication 24,
**caractérisé en ce que**
la polarisation est une polarisation HF (kHz, MHz).

27. Procédé selon l'une quelconque des revendications précédentes,
**caractérisé en ce qu'**
on effectue le revêtement sur des supports fixes ou mobiles.

28. Procédé selon l'une quelconque des revendications précédentes,
**caractérisé en ce qu'**
on utilise des sources de plasmas ou de particules supplémentaires de préférence des micro-ondes, des micro-ondes ECR, des cathodes creuses, des sources d'arc et/ou des vaporisateurs.

29. Application du procédé selon l'une quelconque des revendications 1 à 28 à une installation de traitement par lots ou une installation à passage ou une installation pour des produits en vrac.
